# EUROPÄISCHE PATENTSCHRIFT

(11) **EP 3 894 794 B1**
(45) Veröffentlichungstag und Bekanntmachung des Hinweises auf die Patenterteilung: **08.01.2025**
(21) Anmeldenummer: 19798630.0
(22) Anmeldetag: 06.11.2019
(51) Int. Cl.: G01D 5/20, H03M 1/48

(54) **VORRICHTUNG ZUR ANREGUNG EINES RESOLVERS UND RESOLVERANORDNUNG**
APPARATUS FOR EXCITING A RESOLVER AND RESOLVER ARRANGEMENT
DISPOSITIF D'EXCITATION D'UN RÉSOLVEUR ET ENSEMBLE RÉSOLVEUR

(30) Priorität: 10.12.2018 DE 102018221295
(43) Veröffentlichungstag der Anmeldung: 20.10.2021
(73) Patentinhaber: Robert Bosch GmbH, 70442 Stuttgart (DE)
(72) Erfinder: BRUCKHAUS, Tim, 71679 Asperg (DE)
(86) Internationale Anmeldenummer: PCT/EP2019/080377
(87) Internationale Veröffentlichungsnummer: WO 2020/120035

(56) Entgegenhaltungen:
- EP-A1- 3 223 427
- EP-A2- 2 295 309
- DE-U1- 202015 103 071
- JP-A- 2017 173 013

## Beschreibung

Die vorliegende Erfindung betrifft eine Vorrichtung zur Anregung eines Resolvers, sowie eine Resolveranordnung mit einer solchen Vorrichtung.

### Stand der Technik

Resolver werden in zahlreichen Anwendungsbereichen zur Erfassung einer Winkellage von aktuierten oder nicht aktuierten Drehgelenken, Motoren oder ähnlichem verwendet. Zur Ansteuerung eines Resolvers wird in der Regel ein Erregersignal benötigt. Bei dem Erregersignal kann es sich beispielsweise um ein sinusförmiges Spannungssignal mit einer geeigneten Amplitude und Frequenz handeln. Um das Erregersignal mit einer ausreichenden Treiberleistung bereitzustellen wird in der Regel eine Verstärkerschaltung zur Spannungsverstärkung in Kombination mit einer Gegentaktendstufe zur Stromverstärkung eingesetzt.

Eine Vorrichtung und ein Verfahren zur Bestimmung einer Winkellage mittels eines Resolvers ist beispielsweise aus der Druckschrift DE 10 2009 005 494 A1 bekannt. Hierbei wird eine Erregerwicklung eines Resolvers mit einem Referenzsignal erregt und daraus resultierende Signale zweier weiterer Wicklungen des Resolvers abgetastet und mittels Fourier-Koeffizienten ausgewertet. Aus der Druckschrift JP 2017 173013 A ist eine alternative Vorrichtung zur Anregung eines Resolvers bekannt. Aus der Druckschrift EP 3 223 427 A1 ist eine Verstärkerschaltung mit einer Schaltbrücke, einem Tiefpassfilter und einer induktiven Last bekannt.

### Offenbarung der Erfindung

Die vorliegende Erfindung offenbart eine Vorrichtung zur Anregung eines Resolvers, sowie eine Resolveranordnung mit den Merkmalen der unabhängigen Patentansprüche. Weitere vorteilhafte Ausführungsformen sind Gegenstand der abhängigen Patentansprüche.

### Demgemäß ist vorgesehen:

Eine Vorrichtung zur Anregung eines Resolvers, wie in Anspruch 1 angegeben.

### Weiterhin ist vorgesehen:

Eine Resolveranordnung mit einem Resolver und einer erfindungsgemäßen Vorrichtung zur Anregung des Resolvers. Der Resolver umfasst eine Erregerwicklung mit einem ersten Erregeranschluss und einem zweiten Erregeranschluss.

### Vorteile der Erfindung

Der vorliegenden Erfindung liegt die Erkenntnis zugrunde, dass eine konventionelle Anregung einer Erregerspule für einen Resolver in der Regel eine Leistungsverstärkung eines Erregersignals erfordert. Für diese Leistungsverstärkung wird bei einer konventionellen Ansteuerung vorzugsweise eine Stromverstärkung mit einer Gegentaktendstufe eingesetzt. Dabei arbeiten die Transistoren einer solchen Gegentaktendstufe zumindest zeitweise in einem sogenannten Linearbetrieb und verursachen somit eine hohe Verlustleistung.

Diese hohe Verlustleistung muss als thermische Energie abgeführt werden.

Darüber hinaus wird für eine solche Gegentaktendstufe im Vergleich zur Ausgangsspannung eine relativ hohe Eingangsspannung benötigt. In der Regel muss die Eingangsspannung mindestens doppelt so groß sein wie die gewünschte Signalamplitude am Ausgang.

Der vorliegenden Erfindung liegt daher die Idee zugrunde, dieser Erkenntnis Rechnung zu tragen und eine verbesserte Ansteuerung der Erregerspule eines Resolvers vorzusehen. Insbesondere sollen die elektrischen Verluste während des Bereitstellens der Erregerspannung für den Resolver möglichst gering gehalten werden. Darüber hinaus soll vorzugsweise eine zur Verfügung stehende Versorgungsspannung möglichst effizient genutzt werden können.

Hierzu ist erfindungsgemäß vorgesehen, die elektrische Spannung für die Erregerspule eines Resolvers unter Verwendung mindestens einer Halbbrücke zu erzeugen. Die einzelnen Schaltelemente in der Halbbrücken werden hierbei voll durchgeschaltet. Somit befinden sich die Schaltelemente im Gegensatz zu einer Gegentaktendstufe nicht in einem verlustreichen Linearbetrieb. Vielmehr wird eine Soll-Ausgangsspannung einer Halbbrücke mittels Pulsbreitenmodulation (Englisch: pulse width modulation, PWM) erzeugt.

Gemäß einer Ausführungsform umfasst die Vorrichtung eine zweite Halbbrücke. Die zweite Halbbrücke umfasst ein drittes Schaltelement, das zwischen der Versorgungsspannung und einem zweiten Knotenpunkt angeordnet ist, und ein viertes Schaltelement, das zwischen dem zweiten Knotenpunkt und dem Bezugspotential angeordnet ist. Der zweite Knotenpunkt ist mit dem zweiten Ausgangsanschluss gekoppelt. Die Steuereinrichtung ist dazu ausgelegt, das erste Schaltelement, das zweite Schaltelement, das dritte Schaltelement und das vierte Schaltelement anzusteuern. Entsprechend ist sowohl für den ersten Ausgangsanschluss als auch für den zweiten Ausgangsanschluss jeweils eine separate Halbbrücke vorgesehen.

Die beiden Schaltelemente einer Halbbrücke werden dabei jeweils komplementär zueinander angesteuert. Somit ist entweder nur das Schaltelement zur positiven Versorgungsspannung oder das Schaltelement zur negativen Spannung bzw. dem Bezugspotential geschlossen. Gegebenenfalls kann zur Vermeidung eines Kurzschlusses auch eine Totzeit vorgesehen sein, in der beide Schaltelemente einer Halbbrücke geöffnet sind, bevor eines der beiden Schaltelemente geschlossen wird. Weiterhin können die Schaltelemente der zweiten Halbbrücke komplementär zu den Schaltelementen der ersten Halbbrücke angesteuert werden. Somit wird beispielsweise das Schaltelement der ersten Halbbrücke zwischen positiver Versorgungsspannung und Ausgang geschlossen, wenn in der zweiten Halbbrücke das Schaltelement zwischen negativer Spannung bzw. Bezugspotential geschlossen wird. Analog wird in der ersten Halbbrücke das Schaltelement zwischen Bezugspotential und Ausgangsspannung geschlossen, wenn in der zweiten Halbbrücke das Schaltelement zwischen positiver Versorgungsspannung und Ausgang geschlossen wird. Gegebenenfalls können je nach Anwendungsfall jedoch auch davon abweichende Schaltstrategien verwendet werden.

Bei den Schaltelementen der ersten Halbbrücke und der zweiten Halbbrücke kann es sich beispielsweise um Halbleiterschaltelemente, wie zum Beispiel MOSFETs oder ähnliches handeln. Darüber hinaus sind selbstverständlich auch beliebige andere Schaltelemente, insbesondere beliebige andere Halbleiterschaltelemente möglich. Durch die Verwendung von Halbbrücken, bei denen jeweils die Schaltelemente voll durchgeschaltet werden, kann der volle Spannungsumfang zwischen positiver Versorgungsspannung und negativer Versorgungsspannung bzw. Bezugspotential genutzt werden. Auf diese Weise ist es möglich, die Erregerspannung für den Resolver besonders effizient und verlustarm zu generieren. Insbesondere können hohe elektrische Verluste, wie sie beispielsweise bei Gegentaktendstufen zur Anregung von Resolvern auftreten gemäß dem Stand der Technik, vermieden werden.

Erfindungsgemäß ist Steuereinrichtung mittels eines Mikrocontrollers oder Mikroprozessors realisiert. Gegebenenfalls sind zwischen den Ausgängen des Mikrocontrollers und den Steueranschlüssen der Halbleiterschalter geeignete Treiberstufen für die Halbleiterschaltelemente vorgesehen.

Gemäß einer Ausführungsform ist der erste Ausgangsanschluss dazu ausgelegt mit einem ersten Erregeranschluss eines Resolvers gekoppelt zu werden. Der zweite Ausgangsanschluss ist dazu ausgelegt, mit einem zweiten Erregeranschluss eines Resolvers gekoppelt zu werden. Auf diese Weise kann die Vorrichtung zur Anregung des Resolvers mit der Erregerspule eines Resolvers elektrisch gekoppelt werden, um die Erregerspule des Resolvers mit einer vorbestimmten elektrischen Spannung, insbesondere einer elektrischen Spannung mit einer vorgegebenen Amplitude und/oder einer vorgegebenen Frequenz anzuregen.

Gemäß einer Ausführungsform ist die Steuereinrichtung dazu ausgelegt, an den Steuereingängen des ersten, zweiten, dritten und vierten Schaltelements jeweils ein pulsbreitenmoduliertes Steuersignal bereitzustellen. Durch eine pulsbreitenmodulierte Ansteuerung der Schaltelemente können die einzelnen Schaltelemente voll angesteuert, das heißt durchgeschaltet werden. Auf diese Weise werden die Schaltelemente nicht in einem verlustreichen Linearbetrieb betrieben. Die Frequenz der pulsbreitenmodulierten Steuerung ist dabei signifikant höher als die Grundfrequenz des Spannungssignals, das an der Erregerspule des Resolvers bereitgestellt werden soll. Beispielsweise kann die Frequenz der pulsbreitenmodulierten Ansteuerung das Zehnfache oder gegebenenfalls auch mehr der Grundfrequenz des Spannungssignals sein, das an der Erregerwicklung bereitgestellt werden soll.

Gemäß einer Ausführungsform ist die Steuereinrichtung dazu ausgelegt, eine elektrische Ausgangsspannung zwischen dem ersten Ausgangsanschluss und dem zweiten Ausgangsanschluss zu erfassen. Das erste, zweite, dritte und vierte Schaltelement der ersten und zweiten Halbbrücke kann in diesem Fall unter Verwendung der erfassten Ausgangsspannung angesteuert werden. Auf diese Weise kann ein geschlossener Regelkreis realisiert werden. Somit kann zwischen dem ersten und zweiten Ausgangsanschluss und somit an der Erregerspule eines Resolvers die Erregerspannung für den Resolver präzise eingestellt werden. Insbesondere können auf diese Weise Bauteiltoleranzen und Variationen, beispielsweise aufgrund von thermischen Verschiebungen, bei den charakteristischen Größen der Bauteile kompensiert werden.

Gemäß einer Ausführungsform umfasst die Vorrichtung zur Anregung des Resolvers einen ersten Tiefpassfilter und einen zweiten Tiefpassfilter. Das erste Tiefpassfilter ist zwischen dem ersten Knotenpunkt der ersten Halbbrücke und dem ersten Ausgangsanschluss angeordnet. Das zweite Tiefpassfilter ist zwischen dem zweiten Knotenpunkt der zweiten Halbbrücke und dem zweiten Ausgangsanschluss angeordnet. Mittels der Tiefpassfilter können die höherfrequenten Anteile der pulsbreitenmodulierten Spannung herausgefiltert oder zumindest signifikant abgeschwächt werden. Darüber hinaus können die Tiefpassfilter einen Schwingkreis bilden, der bei Anregung im Bereich der Resonanzfrequenz eine Spannungserhöhung des Ausgangssignals und somit der Erregerspannung für den Resolver bewirken kann. In diesen Schwingkreis kann insbesondere auch die Induktivität des Resolvers mit einbezogen werden.

Gemäß einer Ausführungsform umfasst das erste Tiefpassfilter eine erste Induktivität und einen ersten Kondensator. Das zweite Tiefpassfilter umfasst eine zweite Induktivität und einen zweiten Kondensator. Die erste Induktivität des ersten Tiefpassfilters ist an einem ersten Anschluss mit dem ersten Knotenpunkt der ersten Halbbrücke verbunden. Weiterhin ist die erste Induktivität an einem zweiten Anschluss mit dem ersten Ausgangsanschluss elektrisch gekoppelt. Der erste Kondensator des ersten Tiefpassfilters ist an einem ersten Anschluss mit dem zweiten Anschluss der ersten Induktivität verbunden. Weiterhin ist der erste Kondensator an einem zweiten Anschluss mit dem Bezugspotential verbunden. Die zweite Induktivität des zweiten Tiefpassfilters ist an einem ersten Anschluss mit dem zweiten Knotenpunkt der zweiten Halbbrücke verbunden. Weiterhin ist die zweite Induktivität an einem zweiten Anschluss mit dem zweiten Ausgangsanschluss elektrisch gekoppelt. Der zweite Kondensator des zweiten Tiefpassfilters ist an einem ersten Anschluss mit dem zweiten Anschluss der zweiten Induktivität verbunden. Weiterhin ist der zweite Kondensator an einem zweiten Anschluss mit dem Bezugspotential verbunden. Mittels einer solchen Konfiguration ist eine relativ einfache und kostengünstige Realisation von Tiefpassfiltern möglich. Insbesondere ist es auf diese Weise möglich, höherfrequente Anteile der pulsbreitenmodulierten Ansteuerung der Halbbrücken zu eliminieren und/oder eine Spannungserhöhung der bereitgestellten Signale zu realisieren.

Gemäß einer Ausführungsform umfasst die Vorrichtung zur Ansteuerung eines Resolvers einen ersten Serienkondensator und einen zweiten Serienkondensator. Der erste Serienkondensator ist in dem Strompfad zwischen dem ersten Knotenpunkt und dem ersten Ausgangsanschluss angeordnet. Der zweite Serienkondensator ist in dem Strompfad zwischen dem zweiten Knotenpunkt und dem zweiten Ausgangsanschluss angeordnet. Mittels einer solchen Anordnung von Serienkondensatoren können die Halbbrücken von dem Resolver galvanisch getrennt werden. Auf diese Weise ist ein Schutz der Anordnung, insbesondere der Halbbrücken möglich. Insbesondere ist es mittels der Serienkondensatoren möglich, die Bauelemente der Halbbrücken, wie z.B. die Halbleiterschalter der Halbbrücken, im Falles von Überlast oder bei einem Kurzschluss zu schützen und ggf. irreversiblen Beschädigungen vorzubeugen. Darüber hinaus können die Serienkondensatoren in Kombination mit der Induktivität der Erregerspule des Resolvers einen Schwingkreis bilden. Ferner können auch eventuell vorhandene Induktivitäten von Filterelementen, beisielsweise der oben erwähnten Tiefpassfilter, mit in den Schwingkreis einbezogen werden. Auch dieser Schwingkreis kann zur Spannungserhöhung der Erregerspannung genutzt werden.

Gemäß einer Ausführungsform sind der erste Serienkondensator und der zweite Serienkondensator dazu ausgelegt, gemeinsam mit einer zwischen dem ersten Ausgangsanschluss und dem zweiten Ausgangsanschluss anschließbaren Erregerspule eines Resolvers einen Serienschwingkreis zu bilden. Sind die Kapazitäten der beiden Serienkondensatoren auf die Induktivität der Erregerspule des Resolvers abgestimmt und bilden zusammen einen Serienschwingkreis, so kann hierdurch eine Spannungserhöhung erreicht werden. Auf diese Weise kann die Erregerspule mit einer Spannung angeregt werden, welche höher ist als die zwischen dem ersten und zweiten Knotenpunkte der Halbbrücken bereitgestellte elektrische Spannung. Insbesondere kann die Spannung zur Anregung der Erregerspule größer sein als die Versorgungsspannungen der Vorrichtung zur Anregung des Resolvers.

Gemäß einer Ausführungsform umfasst die Vorrichtung zur Anregung eines Resolvers einen ersten Widerstand und einen zweiten Widerstand. Der erste Widerstand ist zwischen dem ersten Ausgangsanschluss und einem dritten Knotenpunkt angeordnet. Der zweite Widerstand ist zwischen dem zweiten Ausgangsanschluss und dem dritten Knotenpunkt angeordnet. Ferner kann der dritte Knotenpunkt mit einem Bezugspotential elektrisch gekoppelt sein. Durch eine solche Konfiguration zweier Widerstände, insbesondere zweier hochohmiger Widerstände, kann eine Symmetrisierung der elektrischen Spannung zwischen den beiden Ausgangsanschlüssen bezüglich des Bezugspotentials erreicht werden.

Alternativ ist es auch möglich dass der erste Widerstand zwischen dem ersten Ausgangsanschuss und einem ersten Spannungspotential angeordnet ist, und der zweite Widerstand zwischen dem zweiten Ausgangsanschuss und einem zweiten Spannungspotential angeordnet ist. Insbesondere kann eines der beiden Spanungspotentiales, z.B. das zweite Spannungspotential das Bezugspotential sein.

### Kurze Beschreibung der Zeichnungen

Die vorliegende Erfindung wird nachfolgend anhand der in den schematischen Figuren der Zeichnungen angegebenen Ausführungsbeispiele näher erläutert. Dabei zeigen:
- Figur 1:: eine schematische Darstellung einer Resolveranordnung mit einer Vorrichtung zur Anregung eines Resolvers gemäß einer Ausführungsform;
- Figur 2:: eine schematische Darstellung eines Blockschaltbilds einer Resolveranordnung mit einer Vorrichtung zur Anregung eines Resolvers gemäß einer weiteren Ausführungsform; und
- Figur 3:: eine schematische Darstellung eines Blockschaltbilds einer Resolveranordnung mit einer Vorrichtung zur Anregung eines Resolvers gemäß noch einer weiteren Ausführungsform.

### Ausführungsformen der Erfindung

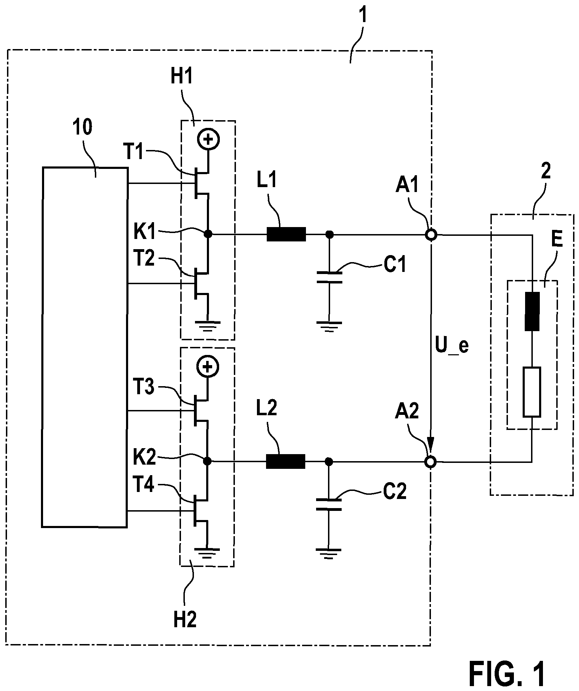

Figur 1 zeigt eine schematische Darstellung eines Prinzipschaltbilds, wie es einer Vorrichtung 1 zur Ansteuerung eines Resolvers 2 gemäß einer Ausführungsform zugrunde liegt. Die Vorrichtung 1 zur Ansteuerung des Resolvers 2 umfasst in dieser Ausführungsform eine Steuereinrichtung 10, eine erste Halbbrücke H1 und eine zweite Halbbrücke H2. Die erste Halbbrücke H1 umfasst ein erstes Schaltelement T1 und ein zweites Schaltelement T2. Das erste Schaltelement T1 ist mit einem Anschluss an einer Versorgungsspannung angeschlossen. Ein weiterer Anschluss der ersten Schaltelements T1 ist mit einem ersten Knotenpunkt K1 verbunden. Der Steueranschluss des ersten Schaltelements T1 ist mit der Steuereinrichtung 10 verbunden. Das zweite Schaltelement T2 ist mit einem ersten Anschluss mit dem ersten Knotenpunkt K1 verbunden. Ein zweiter Anschluss des Steuerelements T2 ist mit einem Bezugspotential verbunden. Ein Steueranschluss des zweiten Schaltelements T2 ist mit der Steuereinrichtung 10 verbunden. Analog zu der ersten Halbbrücke H1 umfasst auch die zweite Halbbrücke H2 zwei Schaltelemente T3 und T4. Das dritte Schaltelement T3 der zweiten Halbbrücke H2 ist mit einem ersten Anschluss mit einer Versorgungsspannung verbunden. Ein zweiter Anschluss des dritten Schaltelements T3 ist mit einem zweiten Knotenpunkt K2 verbunden. Ein erster Anschluss des vierten Schaltelements T4 ist mit dem zweiten Knotenpunkt K2 verbunden. Ein weiterer Anschluss des vierten Schaltelements T4 ist mit dem Bezugspotential verbunden. Die Steueranschlüsse des dritten und vierten Schaltelements T3, T4 sind ebenfalls mit der Steuereinrichtung 10 verbunden.

Bei den Schaltelementen T1 bis T4 der ersten und zweiten Halbbrücke H1 und H2 kann es sich um beliebige Schaltelemente handeln. Insbesondere sind Halbleiterschaltelemente, beispielsweise MOSFET oder ähnliches möglich.

Die Steuereinrichtung 10 generiert pulsbreitenmodulierte Ansteuersignale zum getakteten Öffnen und Schließen der Schaltelemente T1 bis T4.

In einer besonders einfachen Ausführungsform kann der erste Knotenpunkt K1 direkt mit einem ersten Ausgangsanschluss A1 verbunden werden. Analog kann der zweite Knotenpunkt K2 direkt mit einem zweiten Ausgangsanschluss A2 verbunden werden. Zwischen dem ersten Ausgangsanschluss A1 und dem zweiten Ausgangsanschluss A2 kann auf diese Weise eine elektrische Spannung U_e bereitgestellt werden. Diese elektrische Spannung U_e kann dazu genutzt werden, eine Erregerspule E eines Resolvers 2 zu speisen.

Zwischen den beiden Halbbrücken H1, H2 und den Ausgangsanschlüssen A1, A2 kann weiterhin eine Filtereinrichtung vorgesehen sein. Die Filtereinrichtung umfasst ein erstes Tiefpassfilter, das zwischen dem ersten Knotenpunkt K1 und dem ersten Ausgangsanschluss A1 vorgesehen sein kann. Weiterhin umfasst die Filtereinrichtung 21 ein zweites Tiefpassfilter, das zwischen dem zweiten Knotenpunkt K2 und dem zweiten Ausgangsanschluss A2 vorgesehen sein kann. Das erste Tiefpassfilter kann eine erste Induktivität L1 und eine erste Kapazität C1 umfassen. Die erste Induktivität L1 kann zwischen dem ersten Knotenpunkt K1 und dem ersten Ausgangsanschluss A1 vorgesehen sein. Der erste Kondensator C1 kann zwischen dem Bezugspotential und dem Anschluss der ersten Induktivität L1 vorgesehen sein, die dem ersten Ausgangsanschluss A1 zugewandt ist. Analog kann zwischen dem zweiten Knotenpunkt K2 und dem zweiten Ausgangsanschluss A2 eine zweite Induktivität L2 vorgesehen sein, und ein zweiter Kondensator C2 kann zwischen einem Bezugspotential und dem Anschluss der zweiten Induktivität L2, welche dem zweiten Ausgangsanschluss A2 zugewandt ist, vorgesehen sein. Auf diese Weise können mittels der beiden Tiefpassfilter höherfrequente Anteile der an den Knotenpunkten K1 und K2 bereitgestellten elektrischen Spannungssignale herausgefiltert oder zumindest reduziert werden. Darüber hinaus können durch die oben beschriebenen Tiefpassfilteranordnungen jeweils Schwingkreise gebildet werden. Werden diese Schwingkreise im Bereich der Resonanzfrequenz angeregt, so ist hierdurch eine Spannungserhöhung der an den Knotenpunkten K1 und K2 bereitgestellten elektrischen Spannungen möglich. Auf diese Weise ist es prinzipiell möglich, an den Ausgangsanschlüssen A1 und A2 eine elektrische Spannung bereitzustellen, welche gegebenenfalls sogar höher ist als die Versorgungsspannung, welche die Halbbrücken H1 und H2 speist.

Zur Erzeugung der Erregerspannung U_e für eine Erregerspule E eines Resolvers 2 werden das erste, zweite, dritte und vierte Schaltelement T1 bis T4 von der Steuereinrichtung 10 in geeigneter Weise angesteuert. Insbesondere erfolgt hierbei eine pulsbreitenmodulierte Ansteuerung der vier Schaltelemente T1 bis T4. Bei dieser Ansteuerung sind die angesteuerten Schaltelemente jeweils vollständig durchgeschaltet, das heißt geschlossen. Im nicht angesteuerten Zustand sind die entsprechenden Schaltelemente vollständig geöffnet. Es erfolgt somit kein Linearbetrieb der Schaltelemente, in denen die Schaltelemente jeweils nur teilweise leitend sind.

Die Steuereinrichtung 10 steuert die beiden Schaltelemente T1 bis T4 der Halbbrücken H1 und H2 jeweils komplementär an. Das heißt, es ist entweder das obere Schaltelement T1 bzw. T3 leitend, welches mit der Versorgungsspannung verbunden ist, oder ist alternativ das untere Schaltelement T2, T4 leitend, welches mit dem Bezugspotential verbunden ist. Gegebenenfalls kann bei einem Wechsel der Ansteuerung jeweils eine vorgegebene Totzeit vorgesehen sein, in der sowohl das obere (T1, T3) als auch das untere (T2, T4) Schaltelement gleichzeitig geöffnet sind. Auf diese Weise kann sichergestellt werden, dass ein Kurzschluss zwischen der Versorgungsspannung und dem Bezugspotential während des Schaltvorgangs vermieden wird. Die Trägerfrequenz der pulsbreitenmodulierten Ansteuerung der Schaltelemente T1 bis T4 ist dabei signifikant größer als eine Grundfrequenz des Erregersignals U_e, welches an der Erregerspule E des Resolvers 2 bereitgestellt werden soll. Beispielsweise kann die pulsbreitenmodulierte Ansteuerung mit einer Taktrate von dem Zehnfachen oder mehr der Grundfrequenz erfolgen.

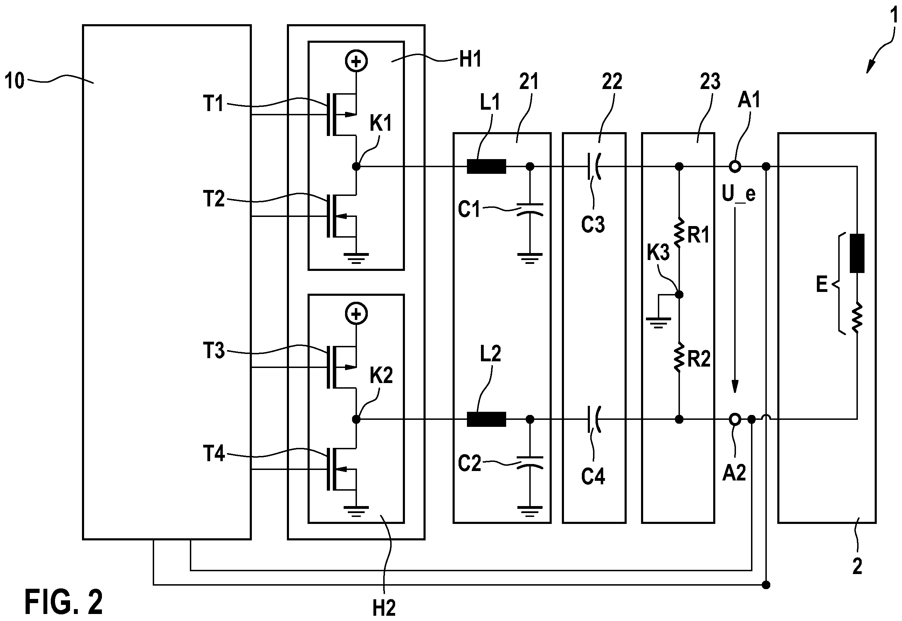

Figur 2 zeigt ein Prinzipschaltbild einer Resolveranordnung mit einer Vorrichtung 1 zur Anregung eines Resolvers 2 gemäß einer weiteren Ausführungsform. Für diese Ausführung gelten alle bereits im Zusammenhang mit Figur 1 gemachten Erläuterungen. Figur 2 unterscheidet sich von Figur 1 insbesondere dadurch, dass die Anordnung 1 optional Serienkondensatoren 22 und/oder ein Modul 23 zur Einstellung eines Gleichspannungspotentials umfasst. Darüber hinaus kann eine Rückkopplung der Ausgangsspannung U_e an der Steuereinrichtung 10 vorgesehen sein.

Wie in Figur 2 zu erkennen ist, kann zwischen dem ersten Knotenpunkt, insbesondere zwischen dem ersten Tiefpassfilter und dem ersten Ausgangsanschluss A1 ein erster Serienkondensator C3 vorgesehen sein. Analog kann zwischen dem zweiten Knotenpunkt K2, insbesondere zwischen dem zweiten Tiefpassfilter und dem zweiten Ausgangsanschluss A2 ein zweiter Serienkondensator C4 vorgesehen sein. Auf diese Weise können mittels der beiden Serienkondensatoren C3 und C4 die Ausgangsanschlüsse A1 und A2 mit der daran angeschlossenen Erregerspule E von den beiden Halbbrücken H1 und H2 galvanisch entkoppelt werden. Darüber hinaus können die beiden Serienkondensatoren C3 und C4 gemeinsam mit der Induktivität der Erregerspule E des Resolvers 2 einen Schwingkreis bilden. Dieser Schwingkreis kann neben den Kapazitäten der Seriencondensatoren C1, C2 und der Resolverinduktivität auch weitere Komponenten, wie zum Beispiel die Induktivitäten L1, L2 der Tiefpassfilter, umfassen. Die Resonanzfrequenz dieses Schwingkreises kann insbesondere auf die Grundfrequenz der Erregerspannung U_e abgestimmt sein. Auf diese Weise kann mittels des in Resonanz betriebenen Schwingkreises oder des nahe des Resonanzpunktes betriebenen Schwingkreies eine Erhöhung der Ausgangsspannung U_e erreicht werden.

Je nach Anwendungsfall können gegebenenfalls anstelle der Induktivitäten L1,L2 auch Widerstände oder andere geeignete elektriche Bauelemente eingesetzt werden.

Darüber hinaus ist es beispielsweise mittels des Moduls 23 möglich, das Gleichspannungspotential der Ausgangsspannung U_e einzustellen. Hierzu kann ein erster Widerstand R1 zwischen dem ersten Ausgangsanschluss A1 und einem dritten Knotenpunkt K3 vorgesehen sein. Weiterhin kann ein zweiter Widerstand R2 zwischen dem zweiten Ausgangsanschluss A2 und dem dritten Knotenpunkt K3 vorgesehen sein. Gegebenenfalls kann der dritte Knotenpunkt K3 mit einem Bezugspotential oder einem vorgegebenen Spannungspotential verbunden sein.

Alternativ ist es auch möglich, dass der erste Widerstand R1 und der zweite Widerstand R2 nicht an einem gemeinsamen dritten Knotenpunkt K3 miteinander verbunden sind. Beispielsweise kann der erste Widerstand R1 zwischen dem ersten Ausgangsanschluss A1 und einem ersten Spannungspotenzial angeordnet sein, und der zweite Widerstand R2 kann zwischen den zweiten Ausgangsanschluss A2 und einem zweiten Spannungpotenzial angeordnet sein. Hierbei kann eines der beiden Spannungspotenziale beispielsweise ein Bezugspotenzial sein.

Bei dem ersten Widerstand R1 und den zweiten Widerstand R2 kann es sich insbesondere um relativ hochohmige Widerstände im Bereich von Kiloohm oder gegebenenfalls Megaohm handeln.

Für einen geschlossenen Regelkreis kann die zwischen dem ersten Ausgangsanschluss A1 und dem zweiten Ausgangsanschluss A2 bereitgestellte Ausgangsspannung U_e direkt oder über eine beliebige geeignete Erfassungsschaltung an der Steuereinrichtung 10 bereitgestellt werden. Auf diese Weise kann die Steuereinrichtung 10 die pulsbreitenmodulierte Ansteuerung der Schaltelemente T1 bis T4 der ersten und zweiten Halbbrücke unter Verwendung der erfassten Ausgangsspannung U_e anpassen. Dies ermöglicht ein sehr präzises Einstellen der Ausgangsspannung U_e. Insbesondere können auf diese Weise auch Bauteiltoleranzen der Komponenten der Vorrichtung 1 sowie Variationen in den charakteristischen Größen der Erregerspule E des Resolvers 2 kompensiert werden. Ferner ist es auch möglich, Schwankungen in den charakteristischen Größen der Bauteile, beispielsweise aufgrund von Erwärmungen oder Abkühlungen, Alterungseffekten oder ähnlichem zu berücksichtigen und zu kompensieren.

Bei der Steuereinrichtung 10 kann es sich um eine beliebige Steuereinrichtung handeln, welche dazu geeignet ist, Steuersignale für eine pulsbreitenmodulierte Ansteuerung der Schaltelemente T1 bis T4 der ersten und zweiten Halbbrücke H1, H2 bereitzustellen. Gegebenenfalls können die von der Steuereinrichtung 10 bereitgestellten Steuersignale mittels geeigneter Treiberstufen (nicht dargestellt) verstärkt werden, um die entsprechende Leistung zur Ansteuerung der Schaltelemente T1 bis T4 bereitzustellen. Die Steuereinrichtung 10 kann beispielsweise mittels eines entsprechend konfigurierten bzw. programmierten Mikrocontrollers oder ähnlichem realisiert werden.

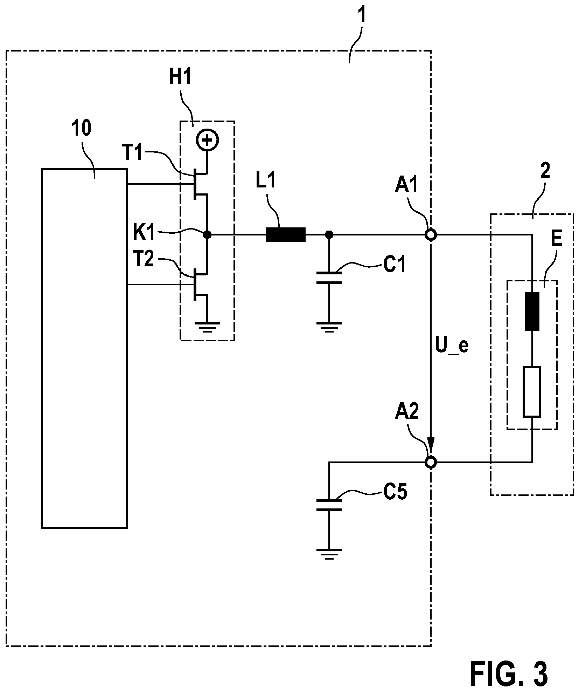

In einer weiteren Ausführungsform kann beispielsweise eine der beiden Halbbrücken H1 oder H2 entfallen. Figur 3 zeigt ein Prinzipschaltbild einer Resolveranordnung mit einer Vorrichtung 1 zur Anregung eines Resolvers 2 gemäß einer Ausführungsform mit nur einer Halbbrücke H1. Darüber hinaus gelten jedoch für die Vorrichtung 1 gemäß Figur 3 auch alle zuvor in Zusammenhang mit Figur 1 oder Figur 2 gemachten Ausführungen. Insbesondere kann zwischen dem ersten Knotenpunkt K1 und dem ersten Ausgangsanschluss A1 ein Tiefpassfilter, beispielsweise aus Induktivität L1 sowie dem Kondensator C2 vorgesehen sein. Ebenso kann beispielsweise zwischen dem ersten Knotenpunkt K1, insbesondere zwischen dem ersten Filterelement einerseits und dem ersten Ausgangsanschluss A1 andererseits ein Serienkondensator C3 vorgesehen sein.

Bei einer Vorrichtung 1 mit nur eine Halbbrücke K1 kann beispielsweise der zweite Ausgangsanschluss A2 über einen Kondensator, hier als Kondensator C5 dargestellt, mit einem Spannungspotenzial, beispielsweise dem Bezugspotenzial verbunden sein. In diesem Fall kann die Kapazität des Kondensators C5 relativ groß bemessen sein.

Zusammenfassend betrifft die vorliegende Erfindung das Bereitstellen einer elektrischen Spannung zur Anregung einer Erregerspule eines Resolvers. Die elektrische Spannung zur Anregung der Erregerspule des Resolvers wird dabei mittels einer pulsbreitenmodulierten Ansteuerung mindestens einer Halbbrücken generiert. Dabei werden die Schaltelemente der Halbbrücken voll durchgeschaltet, so dass Verluste, wie sie beispielsweise im Linearbetrieb von Halbleiterschaltern auftreten, vermieden werden können. Gegebenenfalls kann mittels geeigneter Schwingkreise die von der oder den Halbbrücken bereitgestellte Spannung zusätzlich erhöht werden.

## Patentansprüche

1. Vorrichtung (1) zur Anregung eines Resolvers (2), mit:
einem ersten Ausgangsanschluss (A1), der dazu ausgelegt ist, mit einem ersten Erregeranschluss des Resolvers (2) gekoppelt zu werden,
einem zweiten Ausgangsanschluss (A2) dazu ausgelegt ist, mit einem zweiten Erregeranschluss des Resolvers (2) gekoppelt zu werden,
einer ersten Halbbrücke (H1), mit einem ersten Schaltelement (T1), das zwischen einer Versorgungsspannung und einem ersten Knotenpunkt (K1) angeordnet ist, und einem zweiten Schaltelement (T2), das zwischen dem ersten Knotenpunkt (K1) und einem Bezugspotential angeordnet ist, wobei der erste Knotenpunkt (K1) mit dem ersten Ausgangsanschluss (A1) gekoppelt ist; und
einer Steuereinrichtung (10), die dazu ausgelegt ist, das erste Schaltelement (T1) und das zweite Schaltelement (T2) anzusteuern,
**dadurch gekennzeichnet, dass**
die Steuereinrichtung (10) durch einen Mikrocontroller oder einen Mikroprozessor
realisiert ist und dazu ausgelegt ist, an Steuereingängen der Schaltelemente (T1 bis T4) jeweils ein pulsbreitenmoduliertes Steuersignal bereitzustellen, wobei die einzelnen Schaltelemente (T1, T2) in der Halbbrücke voll durchgeschaltet werden.

2. Vorrichtung (1) nach Anspruch 1, mit einem ersten Tiefpassfilter, der zwischen dem ersten Knotenpunkt (K1) und dem ersten Ausgangsanschluss (A1) angeordnet ist.

3. Vorrichtung (1) nach Anspruch 2, wobei das erste Tiefpassfilter eine erste Induktivität (L1) und einen ersten Kondensator (C1) umfasst, wobei die erste Induktivität (L1) an einem ersten Anschluss mit dem ersten Knotenpunkt (K1) der ersten Halbbrücke (H1) verbunden ist und an einem zweiten Anschluss mit dem ersten Ausgangsanschluss (A1) elektrisch gekoppelt ist, und der erste Kondensator (C1) an einem ersten Anschluss mit dem zweiten Anschluss der ersten Induktivität (L1) verbunden ist und an einem zweiten Anschluss mit dem Bezugspotential verbunden ist.

4. Vorrichtung (1) nach einem der Ansprüche 1 bis 3, mit einer zweiten Halbbrücke (H2) mit einem dritten Schaltelement (T3), das zwischen der Versorgungsspannung und einem zweiten Knotenpunkt (K2) angeordnet ist, und einem vierten Schaltelement (T4), das zwischen dem zweiten Knotenpunkt (K2) und dem Bezugspotential angeordnet ist, wobei der zweite Knotenpunkt (K2) mit dem zweiten Ausgangsanschluss (A2) gekoppelt ist;
wobei die Steuereinrichtung (10), dazu ausgelegt ist, das erste Schaltelement (T1), das zweite Schaltelement (T2), das dritte Schaltelement (T3) und das vierte Schaltelement (T4) anzusteuern.

5. Vorrichtung (1) nach einem der Ansprüche 1 bis 4, wobei die Steuereinrichtung (10) dazu ausgelegt ist, eine elektrische Ausgangsspannung (U_e) zwischen dem ersten Ausgangsanschluss (A1) und dem zweiten Ausgangsanschluss (A2) zu erfassen, und die Schaltelemente (T1 bis T4) unter Verwendung der erfassten Ausgangsspannung (U_e) anzusteuern.

6. Vorrichtung (1) nach einem der Ansprüche 1 bis 5, mit einem zweiten Tiefpassfilter, der zwischen dem zweiten Knotenpunkt (K2) und dem zweiten Ausgangsanschluss (A2) angeordnet ist.

7. Vorrichtung (1) nach Anspruch 6,
wobei das zweite Tiefpassfilter eine zweite Induktivität (L2) und einen zweiten Kondensator (C2) umfasst, wobei die zweite Induktivität (L2) an einem ersten Anschluss mit dem zweiten Knotenpunkt (K2) der zweiten Halbbrücke (H2) verbunden ist und an einem zweiten Anschluss mit dem zweiten Ausgangsanschluss (A2) elektrisch gekoppelt ist, und der zweite Kondensator (C2) an einem ersten Anschluss mit dem zweiten Anschluss der zweiten Induktivität (L2) verbunden ist und an einem zweiten Anschluss mit dem Bezugspotential verbunden ist.

8. Vorrichtung (1) nach einem der Ansprüche 4 bis 7, mit einem ersten Serienkondensator (C3), der zwischen dem ersten Knotenpunkt (K1) und dem ersten Ausgangsanschluss (A1) angeordnet ist; und
mit einem zweiten Serienkondensator (C4), der zwischen dem zweiten Knotenpunkt (K2) und dem zweiten Ausgangsanschluss (A2) angeordnet ist.

9. Vorrichtung (1) nach Anspruch 8, wobei der erste Serienkondensator (C3) und der zweite Serienkondensator (C4) dazu ausgelegt sind, mit einer zwischen dem ersten Ausgangsanschluss (A1) und dem zweiten Ausgangsanschluss (A2) anschließbaren Erregerspule (E) eines Resolvers (2) einen Serienschwingkreis zu bilden.

10. Vorrichtung (1) nach einem der Ansprüche 4 bis 9, mit einem ersten Widerstand (R1), der zwischen dem ersten Ausgangsanschluss (A1) und einem ersten Spannungspotential angeordnet ist, und
mit einem zweiten Widerstand (R2), der zwischen dem zweiten Ausgangsanschluss (A2) und einem vierten Spannungspotential angeordnet ist.

11. Vorrichtung nach Anspruch 10, wobei das dritte Spannungspotential und das vierte Spannungspotential gleich sind.

12. Resolveranordnung, mit:
einem Resolver (2), umfassend eine Erregerspule (E) mit einem ersten Erregeranschluss und einem zweiten Erregeranschluss; und
einer Vorrichtung (1) zur Anregung des Resolvers (2) gemäß einem der Ansprüche 1 bis 11.

## Claims

1. Device (1) for exciting a resolver (2), having:
a first output connection (A1), designed to be coupled to a first excitation connection of the resolver (2),
a second output connection (A2), designed to be coupled to a second excitation connection of the resolver (2),
a first half-bridge (H1), having a first switching element (T1), which is arranged between a supply voltage and a first node (K1), and a second switching element (T2), which is arranged between the first node (K1) and a reference-earth potential, the first node (K1) being coupled to the first output connection (A1); and
a control apparatus (10), designed to control the first switching element (T1) and the second switching element (T2),
**characterized in that**
the control apparatus (10) is realized by
a microcontroller or a microprocessor and is designed to provide a pulse-width-modulated control signal at each of the control inputs of the switching elements (T1 to T4), the individual switching elements (T1, T2) in the half-bridge being switched on to the full extent.

2. Device (1) according to Claim 1, having a first low-pass filter, which is arranged between the first node (K1) and the first output connection (A1).

3. Device (1) according to Claim 2, wherein the first low-pass filter comprises a first inductor (L1) and a first capacitor (C1), wherein the first inductor (L1) is connected by a first connection to the first node (K1) of the first half-bridge (H1) and is electrically coupled by a second connection to the first output connection (A1), and the first capacitor (C1) is connected by a first connection to the second connection of the first inductor (L1) and is connected by a second connection to the reference-earth potential.

4. Device (1) according to one of Claims 1 to 3, having a second half-bridge (H2) having a third switching element (T3), which is arranged between the supply voltage and a second node (K2), and a fourth switching element (T4), which is arranged between the second node (K2) and the reference-earth potential, the second node (K2) being coupled to the second output connection (A2);
wherein the control apparatus (10) is designed to control the first switching element (T1), the second switching element (T2), the third switching element (T3) and the fourth switching element (T4).

5. Device (1) according to one of Claims 1 to 4, wherein the control apparatus (10) is designed to detect an electrical output voltage (U_e) between the first output connection (A1) and the second output connection (A2), and to control the switching elements (T1 to T4) using the detected output voltage (U_e).

6. Device (1) according to one of Claims 1 to 5, having a second low-pass filter, which is arranged between the second node (K2) and the second output connection (A2).

7. Device (1) according to Claim 6,
wherein the second low-pass filter comprises a second inductor (L2) and a second capacitor (C2), wherein the second inductor (L2) is connected by a first connection to the second node (K2) of the second half-bridge (H2) and is electrically coupled by a second connection to the second output connection (A2), and the second capacitor (C2) is connected by a first connection to the second connection of the second inductor (L2) and is connected by a second connection to the reference-earth potential.

8. Device (1) according to one of Claims 4 to 7, having a first series capacitor (C3), which is arranged between the first node (K1) and the first output connection (A1); and
having a second series capacitor (C4), which is arranged between the second node (K2) and the second output connection (A2).

9. Device (1) according to Claim 8, wherein the first series capacitor (C3) and the second series capacitor (C4) are designed to form a series resonant circuit with a field coil (E) of a resolver (2), which field coil is connectable between the first output connection (A1) and the second output connection (A2).

10. Device (1) according to one of Claims 4 to 9, having a first resistor (R1), which is arranged between the first output connection (A1) and a first voltage potential, and
having a second resistor (R2), which is arranged between the second output connection (A2) and a fourth voltage potential.

11. Device according to Claim 10, wherein the third voltage potential and the fourth voltage potential are identical.

12. Resolver arrangement, having:
a resolver (2), comprising a field coil (E) having a first excitation connection and a second excitation connection; and
a device (1) for exciting the resolver (2) according to one of Claims 1 to 11.

## Revendications

1. Dispositif (1) permettant d'exciter un résolveur (2), comprenant :
une première borne de sortie (A1) qui est conçue pour être couplée à une première borne d'excitation du résolveur (2),
une deuxième borne de sortie (A2) qui est conçue pour être couplée à une deuxième borne d'excitation du résolveur (2),
un premier demi-pont (H1) pourvu d'un premier élément de commutation (T1) qui est disposé entre une tension d'alimentation et un premier nœud (K1), et d'un deuxième élément de commutation (T2) qui est disposé entre le premier nœud (K1) et un potentiel de référence, le premier nœud (K1) étant couplé à la première borne de sortie (A1) ; et
un dispositif de commande (10) qui est conçu pour piloter le premier élément de commutation (T1) et le deuxième élément de commutation (T2),
**caractérisé en ce que**
le dispositif de commande (10) est réalisé par
un microcontrôleur ou un microprocesseur et est conçu pour fournir aux entrées de commande des éléments de commutation (T1 à T4) respectivement un signal de commande modulé en largeur d'impulsion, les éléments de commutation (T1, T2) individuels étant entièrement interconnectés dans le demi-pont.

2. Dispositif (1) selon la revendication 1, comprenant un premier filtre passe-bas qui est disposé entre le premier nœud (K1) et la première borne de sortie (A1).

3. Dispositif (1) selon la revendication 2, dans lequel le premier filtre passe-bas comprend une première inductance (L1) et un premier condensateur (C1), dans lequel la première inductance (L1) est reliée au niveau d'une première borne au premier nœud (K1) du premier demi-pont (H1), et est couplée électriquement au niveau d'une deuxième borne à la première borne de sortie (A1), et le premier condensateur (C1) est relié au niveau d'une première borne à la deuxième borne de la première inductance (L1), et est relié au niveau d'une deuxième borne au potentiel de référence.

4. Dispositif (1) selon l'une quelconque des revendications 1 à 3, comprenant un deuxième demi-pont (H2) pourvu d'un troisième élément de commutation (T3) qui est disposé entre la tension d'alimentation et un deuxième nœud (K2), et d'un quatrième élément de commutation (T4) qui est disposé entre le deuxième nœud (K2) et le potentiel de référence, le deuxième nœud (K2) étant couplé à la deuxième borne de sortie (A2) ;
dans lequel le dispositif de commande (10) est conçu pour piloter le premier élément de commutation (T1), le deuxième élément de commutation (T2), le troisième élément de commutation (T3) et le quatrième élément de commutation (T4).

5. Dispositif (1) selon l'une quelconque des revendications 1 à 4, dans lequel le dispositif de commande (10) est conçu pour détecter une tension de sortie (U_e) électrique entre la première borne de sortie (A1) et la deuxième borne de sortie (A2), et pour piloter les éléments de commutation (T1 à T4) en utilisant la tension de sortie (U_e) détectée.

6. Dispositif (1) selon l'une quelconque des revendications 1 à 5, comprenant un deuxième filtre passe-bas qui est disposé entre le deuxième nœud (K2) et la deuxième borne de sortie (A2).

7. Dispositif (1) selon la revendication 6,
dans lequel le deuxième filtre passe-bas comprend une deuxième inductance (L2) et un deuxième condensateur (C2), dans lequel la deuxième inductance (L2) est reliée au niveau d'une première borne au deuxième nœud (K2) du deuxième demi-pont (H2), et est couplée électriquement au niveau d'une deuxième borne à la deuxième borne de sortie (A2), et le deuxième condensateur (C2) est relié au niveau d'une première borne à la deuxième borne de la deuxième inductance (L2) et est relié au niveau d'une deuxième borne au potentiel de référence.

8. Dispositif (1) selon l'une quelconque des revendications 4 à 7, comprenant un premier condensateur série (C3) qui est disposé entre le premier nœud (K1) et la première borne de sortie (A1) ; et
comprenant un deuxième condensateur série (C4) qui est disposé entre le deuxième nœud (K2) et la deuxième borne de sortie (A2).

9. Dispositif (1) selon la revendication 8, dans lequel le premier condensateur série (C3) et le deuxième condensateur série (C4) sont conçus pour former un circuit oscillant série avec une bobine d'excitation (E) d'un résolveur (2), pouvant être connectée entre la première borne de sortie (A1) et la deuxième borne de sortie (A2).

10. Dispositif (1) selon l'une quelconque des revendications 4 à 9, comprenant une première résistance (R1) qui est disposée entre la première borne de sortie (A1) et un premier potentiel de tension, et
comprenant une deuxième résistance (R2) qui est disposée entre la deuxième borne de sortie (A2) et un quatrième potentiel de tension.

11. Dispositif selon la revendication 10, dans lequel le troisième potentiel de tension et le quatrième potentiel de tension sont identiques.

12. Ensemble résolveur, comprenant :
un résolveur (2) comprenant une bobine d'excitation (E) pourvue d'une première borne d'excitation et d'une deuxième borne d'excitation ; et
un dispositif (1) permettant d'exciter le résolveur (2) selon l'une quelconque des revendications 1 à 11.
